# EUROPEAN PATENT APPLICATION

(11) **EP 2 803 983 A1**
(43) Date of publication of application: **19.11.2014**
(21) Application number: 14166408.6
(22) Date of filing: 29.04.2014
(51) Int. Cl.: G01N 25/72

(54) **Infrared non-destructive inspection method and apparatus**

(30) Priority: 14.05.2013 JP 2013102226
(71) Applicant: JTEKT CORPORATION, Osaka-shi Osaka 542-8502 (JP)
(72) Inventor: Matsumoto, Naoki, Osaka-shi, Osaka 542-8502 (JP); Yoshida, Kouya, Osaka-shi, Osaka 542-8502 (JP)
(74) Representative: Winter, Brandl, Fürniss, Hübner, Röss, Kaiser, Polte - Partnerschaft mbB

(57) **Abstract**

In an optical non-destructive inspection method and an optical non-destructive inspection apparatus which can perform inspection accurately in a short time, a measurement object is heated with a laser beam without destroying the measurement object, and a state of the measurement object is determined based on a curve shape of a temperature rise characteristic of the measurement object. In the method and the apparatus, a heating laser beam source (21), at least one infrared detector (31, 32), a control unit (50), and a storage unit (60) are used. The storage unit (60) stores a parameter state-time constant characteristic in which a parameter corresponding to a state of the measurement object is correlated with a time constant indicating the curve shape of the temperature rise characteristic that varies depending on the state of the parameter. The control unit (50) determines the time constant based on the curve shape of the temperature rise characteristic, which extends from a heating start time point to a time point at which a saturated temperature is reached, and determines the state of the parameter of the measurement object based on the determined time constant and the parameter state-time constant characteristic.

## Description

### BACKGROUND OF THE INVENTION

### 1. Field of the Invention

The present invention relates to an optical non-destructive inspection apparatus and an optical non-destructive inspection method.

### 2. Description of Related Art

When an electrode is bonded to a semiconductor chip by wire bonding, the electrode and a wire can be bonded using various methods and it is necessary to inspect whether the electrode and the wire are appropriately bonded to each other. Conventionally, an operator visually inspects a bonding part while the bonding part is enlarged with a microscope or the like, or extracts a predetermined sample, destroys an electrode and a wire to inspect strength thereof or the like. When the bonding part is inspected visually by an operator, reliability of inspection results is low and inspection efficiency is low, because there may be difference in a skill level among operators, or the skill level of one operator may vary due to fatigue, a physical condition, or the like. When destructive inspection is performed on an extracted sample, it is not possible to assure that all the other objects that are not samples and are not actually destroyed (all the other objects that are not extracted) are in the same state as the state of the destroyed sample.

Therefore, in a conventional determination method and a conventional determination apparatus described in Japanese Patent Application Publication No. 2011-191232 (JP 2011-191232 A), in order to determine whether the state of wire bonding with the use of a small-diameter wire is appropriate in a non-contact manner on the basis of an area of a bonding part, a bonding position is heated with a laser beam, a small amount of an infrared light beam emitted from the heated position is detected by using a two-wavelength infrared emission thermometer, and thus, the temperature of the bonding part is measured. A temperature rise characteristic, which is a time history of the temperature of the bonding part from the start of heating until a saturated temperature is reached, is measured, a numerical value correlated with the bonding area is determined based on the measured temperature rise characteristic, and it is determined whether the bonding state is appropriate based on the determined numerical value.

In general, the curve shape of the temperature rise characteristic varies depending on the area of a bonding part of a measurement object. Therefore, it may be determined whether the area of the bonding part is present in an allowable range, based on the curve shape. In the related art, it is determined whether a bonding part is appropriate by using a value (that is, an area in the time history of the temperature) obtained by integrating the temperature rise characteristic with respect to a time axis. When the time-axis integrated value of the temperature rise characteristic of an inspection target is present between the time-axis integrated value of the temperature rise characteristic in an actual sample having a required minimum bonding area and the time-axis integrated value of the time rise characteristic in an actual sample having a required maximum bonding area, it is determined that the inspection target is an appropriate product.

Japanese Patent Application Publication No. 2011-191232 (JP 2011-191232 A) discloses a drawing in which the saturated temperature of a measurement object having a minimum bonding area, the saturated temperature of a measurement object having a maximum bonding area, and the like converge to the same saturated temperature. However, when the bonding area is large, the quantity of heat transfer is large and thus the saturated temperature tends to decrease. When the bonding area is small, the quantity of heat transfer is small and thus the saturated temperature tends to increase. Further, there is a possibility that the saturated temperature may vary depending on a state of a surface irradiated with the heating laser beam, even when the same material is used and the same bonding area is provided. Therefore, since the saturated temperature varies among measurement objects, the time-axis integrated value of the temperature rise characteristic varies depending on the curve shape of the temperature rise characteristic and the value of the saturated temperature. Accordingly, there is a possibility that a correct determination cannot be made based on the curve shape.

In a conventional technology described in Japanese Patent Application Publication No. 2008-145344 (JP 2008-145344 A), a small metal bonding part evaluation method is described, in which a bonding part is heated up to a predetermined temperature with a laser beam, a temperature falling state after stoppage of irradiation with the laser beam is measured by using a temperature-measuring infrared sensor, and it is determined whether a bonding state is appropriate based on the temperature falling state. Further, a reflectance-measuring laser beam and a reflectance-measuring infrared sensor are provided, and reflectance of the bonding part is measured to correct the detected temperature falling state. The time until the temperature reaches the saturated temperature during heating is generally several tens of ms, but the temperature falling time after heating is generally several tens of seconds to several minutes. Accordingly, in the technology in which the temperature falling time is measured, the inspection time is extremely long, which is not preferable.

In another conventional technology described in Japanese Patent No. 4857422, a thermophysical property measuring method and a thermophysical property measuring apparatus are described, in which a sample is fused and floated in a high-frequency coil in a vacuum chamber, a fundamental equation of heat conduction that appropriately represents a method of measuring a thermophysical property value using laser heating is derived, and actual thermophysical property of a conductive material fused at a high temperature can be directly measured. This technology is a method in which a sample is fused and floated by using a large-scaled apparatus and cannot be applied to inspection of the state of wire bonding.

### SUMMARY OF THE INVENTION

One object of the invention is to provide an optical non-destructive inspection apparatus and an optical non-destructive inspection method with which the above-described problem is solved. It is possible to make an accurate determination in a short time according to a method in which a measurement object is heated with a laser beam without destroying the measurement object, and a state of the measurement object is determined based on a curve shape of a temperature rise characteristic of the measurement object.

An aspect of the invention relates to an optical non-destructive inspection method including:
a heating laser irradiation in which a control unit controls a heating laser beam source so as to irradiate a measurement spot set on a measurement object with a heating laser beam;
an emitted-infrared detection in which the control unit detects an infrared light beam with a predetermined infrared wavelength extracted out of light emitted from the measurement spot, by using an infrared detector; and
a temperature rise characteristic measurement in which the control unit measures a temperature rise characteristic based on a detected value detected in the emitted-infrared detection and a heating time during which irradiation with the heating laser beam is performed, the temperature rise characteristic being a temperature rise state of the measurement spot based on the heating time.
The optical non-destructive inspection method is performed by an optical non-destructive inspection apparatus.
The optical non-destructive inspection apparatus includes:
   the heating laser beam source that emits the heating laser beam having a heating laser wavelength and having output power set so as to heat the measurement object without destroying the measurement object;
   at least one infrared detector that detects an infrared light beam;
   the control unit that controls the heating laser beam source and acquires a detection signal form the at least one infrared detector; and
   a storage unit that stores a parameter state-time constant characteristic in which a state of a parameter corresponding to a state of the measurement object to be determined is defined, and a time constant indicating a curve shape of the temperature rise characteristic is correlated with the state of the parameter, the temperature rise characteristic varying depending on the state of the parameter.

The optical non-destructive inspection method according to the above aspect, may further include:
a determination in which the control unit obtaines determines the time constant based on the curve shape of the measured temperature rise characteristic, and determines the state of the parameter of the measurement object based on the determined time constant and the parameter state-time constant characteristic stored in the storage unit.

An interval, in which the curve shape is analyzed when the time constant is determined, may extend from a heating start time point to a time point at which a saturated temperature is reached.

The saturated temperature may be a temperature at which an inclination of a graph indicating a temperature variation with respect to a time variation is equal to or less than a predetermined value.

In the above form, the state of the parameter of the measurement object is determined based on the time constant based on the curve shape of the measured temperature rise characteristic from the heating start time point to the time point at which the saturated temperature is reached and the parameter state-time constant characteristic. For example, even in the case where the saturated temperature of the temperature rise characteristic varies among the measurement objects, if a determination is made on the basis of the time constant of the curve shape and the parameter state-time constant characteristic, it is possible to determine the parameter states of the measurement objects simply from the difference in the curve shapes without being influenced by the difference in the saturated temperatures. Thus, it is possible to make a determination more accurately.

The optical non-destructive inspection method according to the above aspect, may further include:
a determination in which the control unit obtains a normalized temperature rise characteristic by compressing or extending the temperature rise characteristic in a temperature axis direction so that the saturated temperature in the measured temperature rise characteristic is equal to a preset normalized saturated temperature,
the control unit obtains the time constant or information on the time constant based on a curve shape of the obtained normalized temperature rise characteristic, and
the control unit determines the state of the parameter of the measurement object based on the obtained time constant or the obtained information on the time constant and the parameter state-time constant characteristic stored in the storage unit.

An interval, in which the curve shape is analyzed when the time constant or the information on the time constant is obtained, may extend from a heating start time point to a time point at which a saturated temperature is reached.

According to the above form, the normalized temperature rise characteristic is obtained by adjusting the temperature rise characteristic so that the saturated temperature in the measured temperature rise characteristic is equal to a preset normalized saturated temperature. Then, the state of the parameter of the measurement object is determined based on the time constant based on the curve shape of the normalized temperature rise characteristic from the heating start time point to the time point at which the saturated temperature is reached or the information on the time constant and the parameter state-time constant characteristic. For example, even in the case where the saturated temperature of the temperature rise characteristic varies among the measurement objects, if the saturated temperature is set to the normalized saturated temperature, and a determination is made on the basis of the time constant of the curve shape of the normalized temperature rise characteristic or the information on the time constant and the parameter state-time constant characteristic, it is possible to determine the parameter states of the measurement objects simply from the difference in the curve shapes without being influenced by the difference in the saturated temperatures. Thus, it is possible to make a determination more accurately.

In the optical non-destructive inspection method according to the above aspect,
the information on the time constant may be an area of a region surrounded by a temperature rise curve shape of the normalized temperature rise characteristic, and
the area of the region, which extends from the heating start time point to the time point at which the normalized saturated temperature is reached, may be calculated.

Obtaining the area of the region surrounded by the temperature rise curve shape is easier than obtaining the time constant with the use of the control unit. Thus, it is possible to determine the state of the parameter of the measurement object more easily.

In the optical non-destructive inspection method according to the above aspect or any one of the above forms,
the measurement object may be a bonding structure including a bonding part in which two members are bonded,
the measurement spot may be set on a surface of one of the two members,
the state of the parameter may be a magnitude of an area of the bonding part of the two members, and
the control unit may determine whether the area of the bonding part of the two members is in an allowable range by performing the determination.

In the above form, the state of the parameter of the measurement object is the area of the bonding part of the two members. When the two members are, for example, an electrode and a wire, whether the area of a bonding part of the electrode and the wire is in the allowable range is determined. Therefore, it is possible to more appropriately determine whether the state of bonding between the electrode and the wire is appropriate.

In the optical non-destructive inspection method according to the above aspect or any one of the above forms, information on a result of the determination may be displayed on a display unit that displays an image based on an output signal of the control unit.

In the above form, the determination result is displayed on the display unit. By displaying not only the appropriateness of the determination result but also, for example, the measured normalized temperature rise characteristic, the normalized temperature rise characteristic corresponding to the ideal area, the normalized temperature rise characteristic corresponding to the area of the allowable lower limit, the normalized temperature rise characteristic corresponding to the allowable upper limit, which are superimposed on each other, an operator can easily recognize not only the appropriateness but also the amount of deviation from the ideal state toward the lower limit or the upper limit. This is useful for control of the variations in quality of the measurement objects.

Another aspect of the invention relates to an optical non-destructive inspection apparatus that performs the optical non-destructive inspection method according to the above aspect or any one of the above-described forms.

According to this aspect, it is possible to provide the optical non-destructive inspection apparatus that is able to make a determination more accurately even in the state where the saturated temperatures of the measurement objects differ from each other, because the parameter states of the measurement objects can be determined simply from the difference in the time constants corresponding to the curve shapes or the information regarding the time constants without being influenced by the difference in the saturated temperatures.

### BRIEF DESCRIPTION OF THE DRAWINGS

The foregoing and further features and advantages of the invention will become apparent from the following description of example embodiments with reference to the accompanying drawings, wherein like numerals are used to represent like elements and wherein:
FIG. 1A is a diagram illustrating an example of a measurement object, and FIG. 1B is a diagram illustrating an example of a state in which a wire is bonded to an electrode through wire bonding;
FIG. 2 is a diagram illustrating an example of a configuration of an optical non-destructive inspection apparatus;
FIG. 3 is a flowchart illustrating an example of a processing procedure in the optical non-destructive inspection apparatus;
FIG. 4 is a diagram illustrating a relationship among a wavelength of an infrared light beam, energy of the infrared light beam, and a temperature;
FIG. 5 is a diagram illustrating a relationship between a temperature and an energy ratio (two-wavelength ratio) between infrared light beams with two different wavelengths;
FIG. 6 is a diagram illustrating an example of a measured temperature rise characteristic;
FIG. 7 is a diagram illustrating an example of a parameter state-time constant characteristic in which a time constant is correlated with a bonding area (a state of a parameter);
FIG. 8 is a diagram illustrating a normalized temperature rise characteristic obtained by normalizing the temperature rise characteristic by compressing the temperature rise characteristic in a temperature axis direction;
FIG. 9 is a diagram illustrating a normalized temperature rise characteristic obtained by normalizing the temperature rise characteristic by extending the temperature rise characteristic in the temperature axis direction;
FIG. 10 is a diagram illustrating an example where a normalized ideal temperature rise characteristic, a normalized lower-limit temperature rise characteristic, and a normalized upper-limit temperature rise characteristic are displayed in an overlapping manner;
FIG. 11 is a diagram illustrating an area regarding the normalized temperature rise characteristic obtained based on the measured temperature rise characteristic, the area extending from a heating start time point to a predetermined time point (TS);
FIG. 12 is a diagram illustrating an example of a parameter state-time constant characteristic in which the area determined in FIG. 11 (information regarding the time constant) is correlated with the bonding area (the state of the parameter); and
FIG. 13 is a diagram illustrating an example where information on a determination result regarding the state of the measurement object is displayed on a display unit.

### DETAILED DESCRIPTION OF EMBODIMENTS

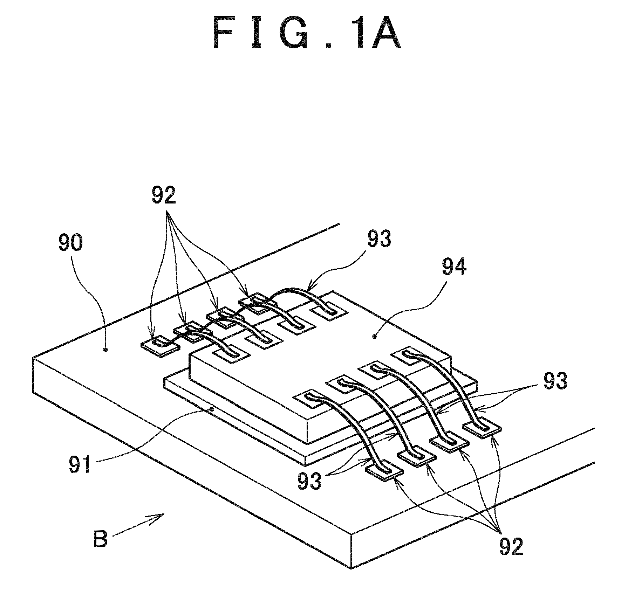

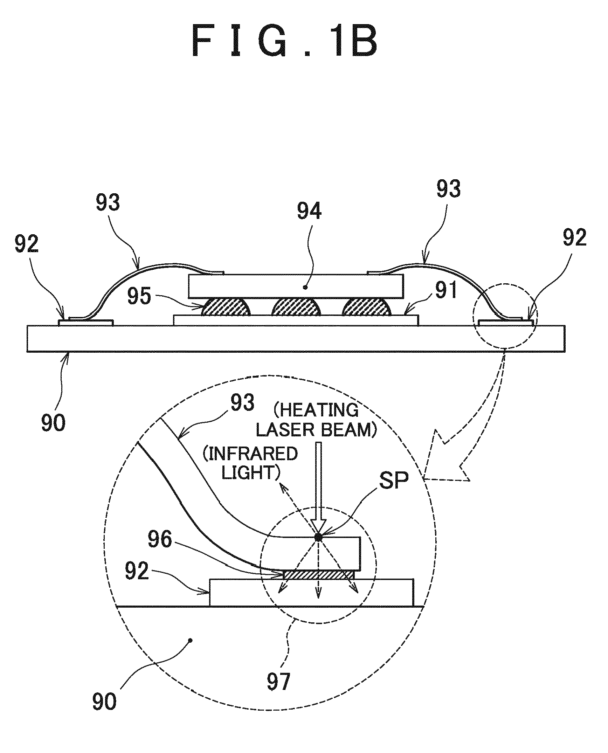

Hereinafter, embodiments of the present invention will be described with reference to the accompanying drawings. A measurement object will be described with reference to FIGS. 1A and 1B. FIG. 1A is a perspective view of a board 90. A first end of a wire 93 that is formed of aluminum or the like and that has a diameter of several tens of µm to several hundreds of µm is mechanically and electrically bonded to each electrode 92 disposed on the board 90 through wire bonding, and a second end of the wire 93 is bonded to each terminal of a semiconductor chip 94 fixed onto the board 90. FIG. 1B is a view of FIG. 1A when viewed in a direction B. In this embodiment, a bonding structure 97 including a bonding part 96 in which the wire 93 and the electrode 92 are bonded to each other is described as a measurement object.

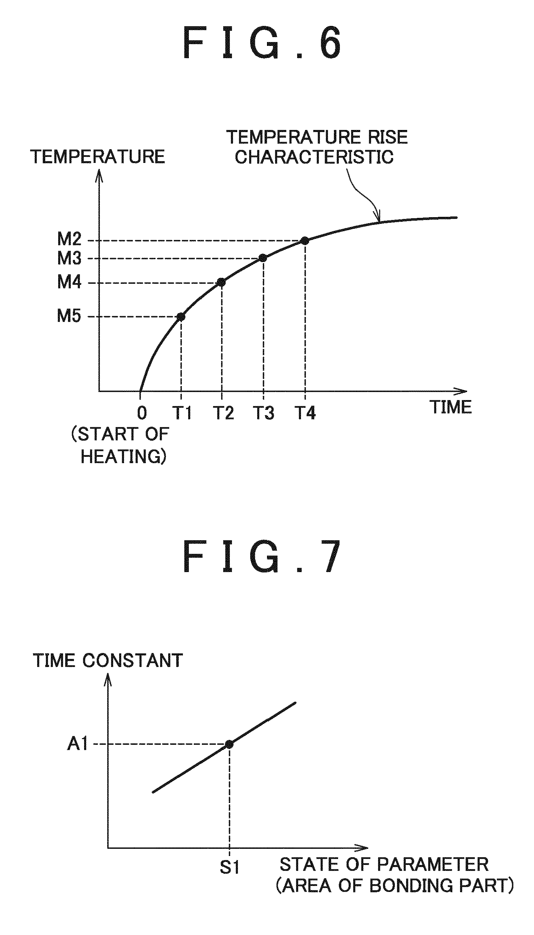

In order to determine whether the wire 93 is appropriately bonded to the electrode 92, it may be determined whether a bonding state is appropriate based on whether the area of the bonding part 96, that is, the area of a region, in which the surface of the wire 93 and the surface of the electrode 92 are parallel to each other in FIG. 1B, is in an allowable range. Therefore, as illustrated in the enlarged view of the bonding structure 97 in FIG. 1B, a measurement spot SP is set on the surface of the wire 93 of the bonding structure 97 and the measurement spot SP is irradiated and heated with a heating laser beam. Then, the temperature of the measurement spot SP gradually rises and heat transfers from the measurement spot SP to the electrode 92 via the inner portion of the wire 93 and the bonding part 96. An infrared light beam corresponding to the raised temperature is emitted from the bonding structure 97 including the measurement spot SP. The temperature of the measurement spot SP gradually rises, and when the temperature reaches a saturated temperature at which the quantity of heat added and the quantity of heat dissipated are equal to each other, the rise in temperature stops and then, the temperature becomes substantially constant in spite of continuous heating. When the area of the bonding part 96 is relatively large, the quantity of heat transferring to the electrode 92 is large, and therefore, the temperature rises relatively gradually with the lapse of a heating time, and the saturated temperature is lowered. When the area of the bonding part 96 is relatively small, the quantity of heat transferring to the electrode 92 is small, and therefore, the temperature rises relatively sharply with the lapse of the heating time, and the saturated temperature is raised. Thus, it is possible to determine whether the bonding state is appropriate by irradiating the measurement spot SP with a heating laser beam, measuring the temperature rise characteristic illustrated in FIG. 6, determining the area of the bonding part 96 on the basis of the temperature rise characteristic, and determining whether the area of the bonding part 96 is in an allowable range.

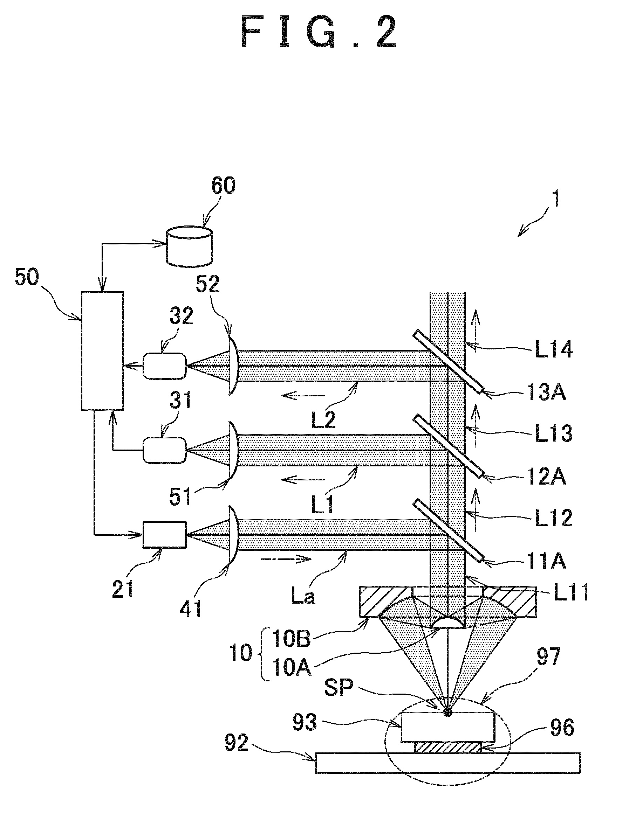

Hereinafter, details of an example of the configuration of an optical non-destructive inspection apparatus and an optical non-destructive inspection method that can determine whether the bonding state is appropriate will be described. An optical non-destructive inspection apparatus 1 illustrated in FIG. 2 includes a focusing-collimating unit 10, a heating laser beam source 21, a heating laser collimating unit 41, a heating-laser selective reflection unit 11A, a first infrared detector 31, a first infrared selective deflector 12A, a first infrared focusing unit 51, a second infrared detector 32, a second infrared selective deflector 13A, a second infrared focusing unit 52, a control unit 50, a storage unit 60, and the like.

The configuration of the optical non-destructive inspection apparatus is not limited to the configuration illustrated in FIG. 2. For example, an optical non-destructive inspection apparatus that includes one infrared detector, a reflectance-measuring laser beam source, and an optical sensor and that corrects a detected value of the infrared detector on the basis of reflectance may be employed.

The focusing-collimating unit 10 emits parallel light, which is incident from a first side (the upper side in FIG. 2) along its own optical axis, from a second side (the lower side in FIG. 2) and focuses the parallel light to the measurement spot SP set on the measurement object as a focal position. The focusing-collimating unit 10 converts light emitted and reflected from the measurement spot SP and incident from the second side, into parallel light along the optical axis and emits the parallel light from the first side. The focusing-collimating unit 10 may be formed by using a focusing lens that transmits and refracts light. However, since light beams with plural different wavelengths are treated, a focusing lens causing chromatic aberration is not preferable. Therefore, by forming the focusing-collimating unit 10 using aspheric reflecting mirrors 10A and 10B, occurrence of chromatic aberration is prevented to cope with a broad wavelength band.

The heating laser beam source 21 emits a heating laser beam, whose output level is adjusted so that the heating laser beam heats the measurement object without destroying the measurement object, on the basis of a control signal from the control unit 50. The wavelength of the heating laser beam is referred to as a heating laser wavelength λa. The heating laser beam source 21 is, for example, a semiconductor laser.

The heating laser beam collimating unit 41 is disposed in the vicinity of the heating laser beam source 21, that is, in the vicinity of a laser beam emission position at a position on the optical axis of the heating laser beam, and converts the heating laser beam emitted from the heating laser beam source 21 into a heating laser beam La that is parallel light. For example, the heating laser beam collimating unit 41 needs to convert only a light beam with the heating laser wavelength λa into parallel light and thus may be a collimation lens. When the heating laser beam source 21 can emit parallel light, the heating laser beam collimating unit 41 may be omitted.

The heating-laser selective reflection unit 11A is disposed on the optical axis of the focusing-collimating unit 10 and reflects the heating laser beam La, which is obtained by converting the heating laser beam emitted from the heating laser beam source 21 into parallel light, to the first side of the focusing-collimating unit 10. The wavelength of the heating laser beam La is the heating laser wavelength λa. The heating-laser selective reflection unit 11A transmits the parallel light beam L12 with a wavelength different from the heating laser wavelength λa out of the parallel light emitted and reflected from the measurement spot SP and emitted from the first side of the focusing-collimating unit 10. For example, the heating-laser selective reflection unit 11A is a dichroic mirror that reflects the light beam with the heating laser wavelength λa and transmits the light beam with a wavelength other than the heating laser wavelength λa. A heating laser beam guide unit is constituted by the heating laser beam collimating unit 41 and the heating-laser selective reflection unit 11A, and the heating laser beam guide unit converts the heating laser beam emitted from the heating laser beam source 21 into parallel light and guides the parallel light to the first side of the focusing-collimating unit 10.

The first infrared detector 31 can detect energy of an infrared light beam emitted from the measurement spot SP. For example, the first infrared detector 31 is an infrared sensor. The detection signals from the first infrared detector 31 are acquired by the control unit 50.

The first infrared selective reflection unit 12A is disposed in the path of the parallel light L12 emitted from the first side of the focusing-collimating unit 10 and transmitted by the heating-laser selective reflection unit 11A, and is disposed on the optical axis of the focusing-collimating unit 10 in the inspection apparatus. The parallel light L12 is parallel light having a wavelength different from the heating laser wavelength. The first infrared selective reflection unit 12A reflects parallel light L1 that is an infrared light beam with a predetermined infrared wavelength λ1 out of the parallel light L12 emitted from the first side of the focusing-collimating unit 10 and transmitted by the heating-laser selective reflection unit 11A, to the first infrared detector 31, and transmits parallel light L13 with a wavelength different from the predetermined infrared wavelength λ1. Therefore, the first infrared detector 31 detects only energy of the infrared light beam with the first infrared wavelength λ1. For example, the first infrared selective reflection unit 12A is a dichroic mirror that reflects the light beam with the predetermined infrared wavelength λ1 and that transmits the light beam with a wavelength other than the predetermined infrared wavelength λ1.

The first infrared focusing unit 51 is disposed in the vicinity of the first infrared detector 31 and focuses the infrared light beam as the parallel light L1 with the first infrared wavelength λ1 reflected by the first infrared selective reflection unit 12A, to the detection position of the first infrared detector 31. For example, since the first infrared focusing unit 51 needs to focus only the light beam with the predetermined infrared wavelength λ1, the first infrared focusing unit 51 may be a focusing lens. A first emitted-infrared guide unit is constituted by the heating-laser selective reflection unit 11A, the first infrared selective reflection unit 12A, and the first infrared focusing unit 51. The first emitted-infrared guide unit extracts an infrared light beam with the first infrared wavelength λ1 out of the parallel light L12 emitted from the measurement spot SP and emitted from the first side of the focusing-collimating unit 10, and guides the extracted infrared light beam to the first infrared detector 31.

The second infrared detector 32 can detect energy of the infrared light beam emitted from the measurement spot SP. For example, the second infrared detector 32 is an infrared light sensor. A detection signal from the second infrared detector 32 is acquired by the control unit 50.

The second infrared selective reflection unit 13A is disposed in a path of parallel light L13 emitted from the first side of the focusing-collimating unit 10 and transmitted by the heating-laser selective reflection unit 11A and the first infrared selective reflection unit 12A, and is disposed on the optical axis of the focusing-collimating unit 10 in this inspection apparatus. The parallel light L13 is parallel light with a wavelength different from the heating laser wavelength and the first infrared wavelength. The second infrared selective reflection unit 13A reflects parallel light L2 as an infrared light beam with the second infrared wavelength λ2 out of the parallel light L13 emitted from the first side of the focusing-collimating unit 10 and transmitted by the heating-laser selective reflection unit 11A and the first infrared selective reflection unit 12A, toward the second infrared detector 32 and transmits parallel light L14 with a wavelength different from the second infrared wavelength λ2. Since the transmitted parallel light L14 is unnecessary, the transmitted parallel light L14 is absorbed, for example, by a light absorbing member. Therefore, the second infrared detector 32 detects only energy of the infrared light beam with the second infrared wavelength λ2. For example, the second infrared selective reflection unit 13A is a dichroic mirror that reflects the light beam with the second infrared wavelength λ2 and transmits a light beam with a wavelength other than the second infrared wavelength λ2.

The second infrared focusing unit 52 is disposed in the vicinity of the second infrared detector 32 and focuses the parallel light L2, which is the infrared light beam with the second infrared wavelength λ2 reflected by the second infrared selective reflection unit 13A, to the detection position of the second infrared detector 32. For example, since the second infrared focusing unit 52 needs focus only the light beam with the second infrared wavelength λ2, the second infrared focusing unit 52 may be a focusing lens. A second emitted-infrared guide unit is constituted by the heating-laser selective reflection unit 11A, the first infrared selective reflection unit 12A, the second infrared selective reflection unit 13A, and the second infrared focusing unit 52. The second emitted-infrared guide unit extracts the infrared light beam with the second infrared wavelength λ2 out of the parallel light L12 emitted from the measurement spot SP and emitted from the first side of the focusing-collimating unit 10, and guides the extracted infrared light beam to the second infrared detector 32.

The control unit 50 is, for example, a personal computer, receives a detection signal from the first infrared detector 31 and a detection signal from the second infrared detector 32 and measures the temperature of the measurement spot SP on the basis of a ratio between the detected value from the first infrared detector 31 and the detected value from the second infrared detector 32, while controlling the heating laser beam source 21 so as to heat the measurement spot SP with the heating laser beam. Then, the control unit 50 measures a temperature rise characteristic that is a temperature rise state of the measurement spot based on the heating time and determines the state of the measurement object on the basis of the measured temperature rise characteristic. The method of measuring the temperature and the detailed operation of the control unit 50 will be described later.

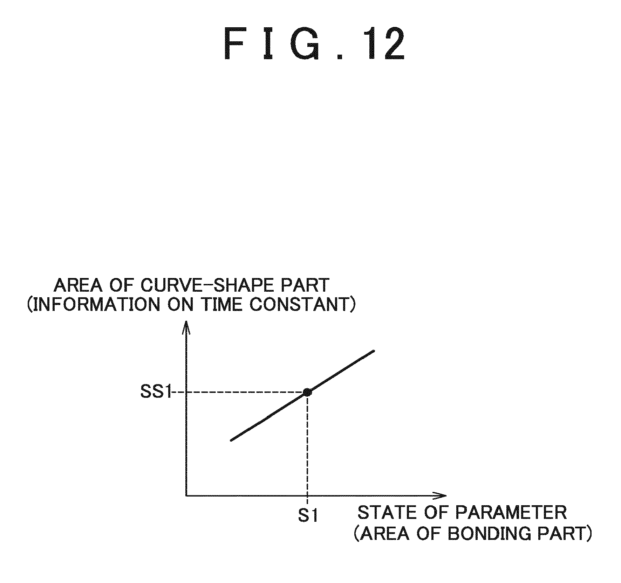

The storage unit 60 is a storage unit such as a hard disk. The storage unit 60 stores a time constant indicating the curve shape of the temperature rise characteristic corresponding to the state of a measurement object to be determined or information on the time constant. The information is stored in the form correlated with a state of a parameter of the measurement object to be determined, that is, in the form of a parameter state-time constant characteristic (see FIGS. 7 and 12).

In the example of the parameter state-time constant characteristic illustrated in FIG. 7, the parameter state is an area of a bonding part. The time constant indicating the curve shape of the temperature rise characteristic is stored in correlation with the area of the bonding part.

The control unit 50 determines the time constant of the measured temperature rise characteristics or the information on the time constant, on the basis of the curve shape of the temperature rise characteristic. The range, in which the temperature rise characteristic is analyzed, extends from the heating start time point to the time point at which the temperature of the measurement spot reaches a saturated temperature. The saturated temperature is a temperature at a time point at which the inclination of the temperature rise characteristic, that is, the variation in temperature per unit time is equal to or less than a predetermined value. The control unit 50 determines a state of a parameter of the measurement object on the basis of the determined time constant or information on the time constant and the parameter state-time constant characteristic stored in the storage unit, and determines whether the determined state of the parameter is present within an allowable range. In this embodiment, the state of the parameter of the measurement object is an area of a bonding part.

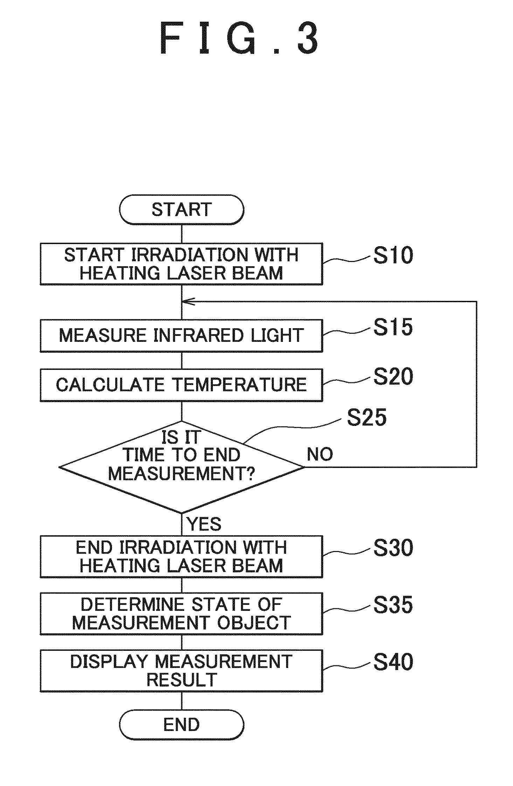

An optical non-destructive inspection method according to a first embodiment of the present invention, which is performed in the processing procedure by the control unit 50 of the optical non-destructive inspection apparatus 1 will be described below with reference to the flowchart illustrated in FIG. 3. The processing illustrated in FIG. 3 is performed by the control unit 50 when a measurement spot is inspected.

In step S10, the control unit 50 controls the heating laser beam source so that the heating laser beam is emitted from the heating laser beam source, and then performs the process of step S15. The heating laser beam is guided to a measurement spot. Step S10 corresponds to a heating laser beam irradiation step in which the control unit controls the heating laser beam source so as to irradiate a measurement spot set on a measurement object with the heating laser beam. The infrared light beam emitted from the measurement spot is guided to the first infrared detector and the second infrared detector.

In step S15, the control unit 50 acquires the detected value of energy of the infrared light beam with the first infrared wavelength λ1 based on the detection signal from the first infrared detector, the detected value of energy of the infrared light beam with the second infrared wavelength λ2 based on the detection signal from the second infrared detector, and the time (heating time) elapsed after the irradiation with the heating laser beam is started in step S10, and then performs the process of step S20. Step S15 corresponds to an emitted-infrared detection step in which the control unit detects an infrared light beam with a predetermined infrared wavelength extracted from the infrared light beam emitted from the measurement spot by using the infrared detector. In this embodiment, the predetermined infrared wavelength corresponds to the first infrared wavelength λ1 and the second infrared wavelength λ2 and the infrared detector corresponds to the first infrared detector and the second infrared detector.

In step S20, the control unit 50 determines the temperature of the measurement spot corresponding to the heating time on the basis of a ratio between the detected value from the first infrared detector and the detected value from the second infrared detector, and then performs the process of step S25. Step S20 corresponds to a temperature rise characteristic measurement step in which the control unit measures the temperature rise characteristic that is the temperature rise state of the measurement spot based on the heating time, on the basis of the detected value detected in the emitted-infrared detection step and the heating time during which the measurement spot is irradiated with the heating laser beam.

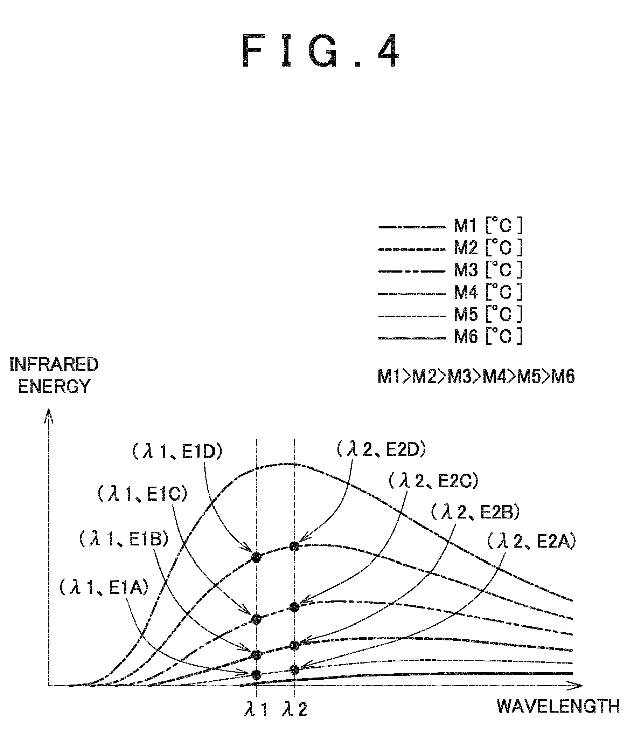

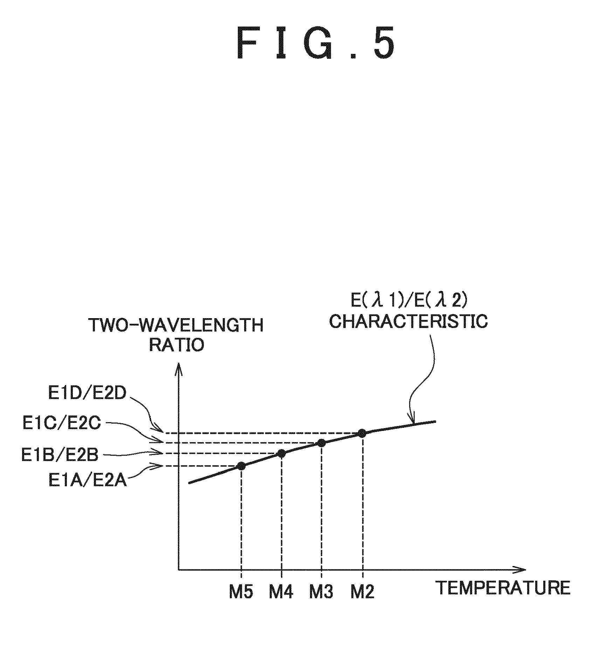

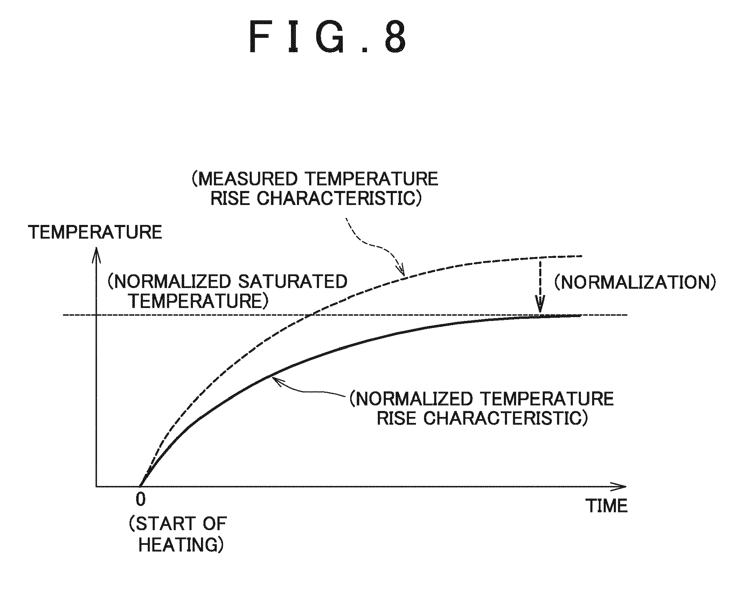

FIG. 4 illustrates an example of an infrared emission characteristic representing the relationship between the wavelength of the infrared light beam radiated from a black body (indicated by the horizontal axis) and energy of the infrared light beam with the corresponding wavelength (indicated by the vertical axis) when the temperature of the black body completely absorbing and radiating irradiated light is each of temperatures (M1, M2, M3, M4, M5, and M6). For example, it is assumed that the measurement spot is a black body, the position of the first infrared wavelength λ1 is the position of λ1 illustrated in FIG. 8 and the position of the second infrared wavelength λ2 is the position of λ2 illustrated in FIG. 8. When the detected value of the energy of the infrared light beam with the first infrared wavelength λ1 detected by the first infrared detector and acquired at the timing of heating time T1 is E1A, and the detected value of the energy of the infrared light beam with the second infrared wavelength λ2 detected by the second infrared detector is E2A, the control unit 50 determines the temperature of the measurement spot based on E1A / E2A that is the ratio (hereinafter, referred to as two-wavelength ratio) between the detected values, and the Eλ1 / Eλ2 characteristic that is a temperature-two-wavelength ratio characteristic as exemplified in FIG. 5. In this case, the temperature is determined to be M5 (°C). The two-wavelength ratio is an energy ratio between the infrared light beams with two different wavelengths. The temperature-two-wavelength ratio characteristic exemplified in FIG. 5 is stored in advance in the storage unit 60.

By using the ratio between the detected values of energy of the infrared light beams with the two wavelengths, the control unit can determine an accurate temperature of the measurement spot without an influence of the reflectance (emissivity) of the measurement spot. In a case where the (energy of the infrared light beam with the first infrared wavelength, energy of the infrared light beam with the second infrared wavelength) acquired at the time points of heating times T2, T3, and T4 are (E1B, E2B), (E1C, E2C), and (E1D, E2D), respectively, it can be determined that the temperatures at the time points of heating times T2, T3, and T4 are M4, M3, and M2, respectively, based on the temperature-two-wavelength ratio characteristic. Thus, the control unit determines the temperature rise characteristic exemplified in FIG. 6 based on the time elapsed after the irradiation is started, that is, the heating time, and the temperature corresponding to the heating time.

In step S25, the control unit 50 determines whether it is time to end the measurement. The control unit 50 determines that it is time to end the measurement when it is determined that the measured temperature reaches a saturated temperature. For example, when a temperature rising value, by which the temperature currently measured in step S20 is higher than the temperature previously measured in step S20 is equal to or less than a predetermined value, the control unit 50 determines that the measured temperature reaches the saturated temperature. The saturated temperature is a temperature when the inclination of the temperature rise characteristic illustrated in FIG. 6 is equal to or less than a predetermined value. After the temperature reaches the saturated temperature, the temperature is almost constant.

The control unit 50 performs the process of step S30 when it is determined that the measured temperature reaches the saturated temperature and it is time to end the measurement (YES), and performs the process of step S15 again when it is determined that it is not time to end the measurement (NO). When the processing returns to step S15 after a predetermined time (for example, about 1 ms) passes, the temperature can be measured at predetermined time intervals, which is preferable.

In step S30, the control unit 50 controls the heating laser beam source so as to stop the irradiation with the heating laser beam, and then performs the process of step S35.

In step S35, the control unit 50 determines the time constant of the temperature rise characteristic (FIG. 6) measured in step S20 on the basis of the curve shape of the temperature rise characteristic. The range, in which the temperature rise characteristic is analyzed, extends from the heating start time point to the time point at which the temperature of the measurement spot reaches the saturated temperature. The method of determining the time constant is not particularly limited. For example, curve shapes corresponding to plural different time constants are stored in the storage unit 60, a curve shape coinciding with or most similar to the temperature rise characteristic determined in step S20 is searched for, and the time constant corresponding to the searched curve shape is output. The time constant may be determined using other methods. The control unit 50 determines the state of a parameter of the measurement object on the basis of the determined time constant and the parameter state-time constant characteristic (FIG. 7) stored in advance in the storage unit 60. In this embodiment, the state of the parameter of the measurement object is an area of a bonding part.

In the parameter state-time constant characteristic (FIG. 7), the state of the parameter is correlated with the time constant. In the example illustrated in FIG. 7, when the time constant of the measured temperature rise characteristic is A1, the control unit 50 determines that the area of the bonding part is equal to S1.

Then, the control unit 50 determines that the bonding state is appropriate when the determined state of the parameter (the area of the bonding part) is present in an allowable range. When the determined state of the parameter (the area of the bonding part) is not present in the allowable range, the control unit determines that the bonding state is not appropriate. Thereafter, the control unit 50 performs the process of step S40. A threshold value used to determine whether the parameter state is present in an allowable range is stored in advance in the storage unit 60. Step S35 corresponding to a determination step.

In step S40, the control unit 50 displays information on the result of the determination step (step S35) on a display unit and ends the processing. The display unit displays a screen based on an output signal from the control unit, and is, for example, a monitor of a personal computer. A display example of the monitor screen will be described later.

In the above-mentioned processing procedure, since the state of the parameter (the area of the bonding part) is determined on the basis of the time constant of the curve shape of the temperature rise characteristic and is determined on the basis of the difference in the curve shape regardless of the difference in the saturated temperature, it is possible to perform more accurate determination. By performing the above-mentioned processing procedure, it is possible to configure an optical non-destructive inspection apparatus in which the control unit determines whether the state of the parameter (the area of the bonding part) of the measurement object (the bonding structure 97) or the area of the bonding part of two members (the wire 93 and the electrode 92) is present in an allowable range.

In the above-mentioned processing procedure according to the first embodiment, the time constant is determined on the basis of the curve shape of the measured temperature rise characteristic in step S35 (the determination step) in FIG. 3. However, the process of determining the time constant is slightly troublesome. In a process procedure according to a second embodiment of the present invention, the area of the bonding part is determined by normalizing the measured temperature rise characteristic and acquiring the information on the time constant instead of using the time constant. The processing procedure according to the second embodiment will be described below.

As described above, the curve shape and the saturated temperature of the temperature rise characteristic vary depending on the area of the bonding part. In a state where the saturated temperature of the temperature rise characteristic varies, it is difficult to determine a difference in the curve shape. The factor causing the curve shape of the temperature rise characteristic to vary is the area of the bonding part, but the factor causing the saturated temperature to vary may include a surface state (unevenness state) of the measurement spot in addition to the area of the bonding part. Therefore, it is not preferable that whether the area of the bonding part is appropriate be determined on the basis of the difference in the saturated temperature, and it is preferable that whether the area of the bonding part is appropriate be determined on the basis of only the difference in the curve shape. Accordingly, in the following processing procedure, the difference in the saturated temperature is excluded and whether the area of the bonding part is appropriate is determined on the basis of only the difference in the curve shape.

In the processing procedure according to the second embodiment, the process of step S35 (the determination step) in the first embodiment is changed as follows. In step S35, the control unit 50 obtains a normalized temperature rise characteristic by compressing or extending the temperature rise characteristic in the temperature axis direction so that the saturated temperature in the temperature rise characteristic (FIG. 6) measured in step S20 is equal to a predetermined normalized saturated temperature. The temperature rise characteristic is not changed in the time axis direction. For example, the normalized saturated temperature is set to the saturated temperature in the temperature rise characteristic of a measurement object in which the area of a bonding part is an ideal value, and the normalized saturated temperature is stored in the storage unit 60.

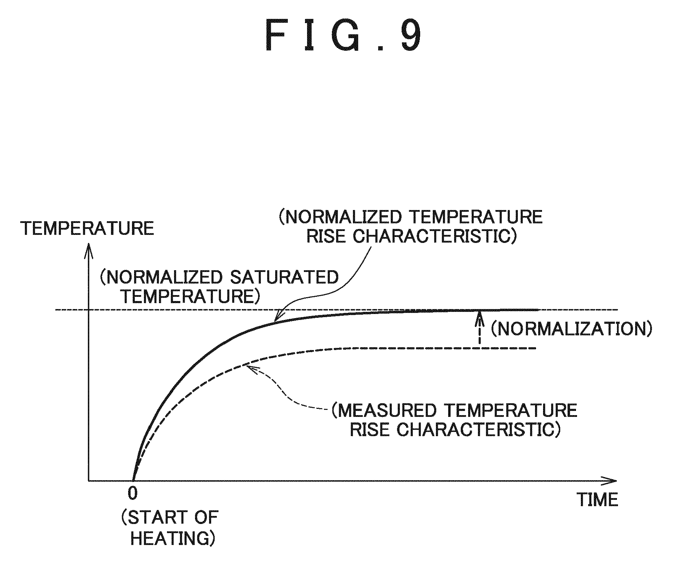

When the saturated temperature of the measured temperature rise characteristic is higher than the normalized saturated temperature, the control unit 50 compresses the temperature rise characteristic in the temperature axis direction so that the saturated temperature in the measured temperature rise characteristic is equal to the normalized saturated temperature as illustrated in FIG. 8, and thus, obtains the normalized temperature rise characteristic. When the saturated temperature in the measured temperature rise characteristic is lower than the normalized saturated temperature, the control unit 50 extends the temperature rise characteristic in the temperature axis direction so that the saturated temperature in the measured temperature rise characteristic is equal to the normalized saturated temperature as illustrated in FIG. 9, and thus, obtains a normalized temperature rise characteristic.

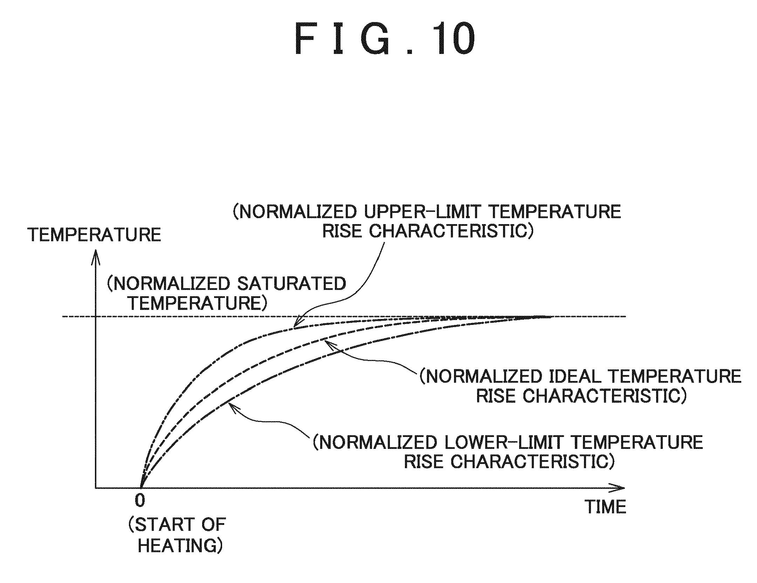

The normalization is a process of compressing or extending the temperature rise characteristic in the temperature axis direction so that the saturated temperature in the measured temperature rise characteristic is equal to a predetermined normalized saturated temperature. FIG. 10 illustrates an example where a normalized ideal temperature rise characteristic obtained by normalizing the temperature rise characteristic of a measurement object in which the area of a bonding part is equal to an ideal value, a normalized lower-limit temperature rise characteristic obtained by normalizing the temperature rise characteristic of a measurement object in which the area of a bonding part is equal to an allowable lower limit value, and a normalized upper-limit temperature rise characteristic obtained by normalizing the temperature rise characteristic of a measurement object in which the area of a bonding part is equal to an allowable upper limit value are displayed in an overlapping manner. As illustrated in FIG. 10, the difference in the area of the bonding part can be expressed by only the difference in the curve shape from the heating start time point to the time point at which the normalized saturated temperature is reached, by performing the normalization.

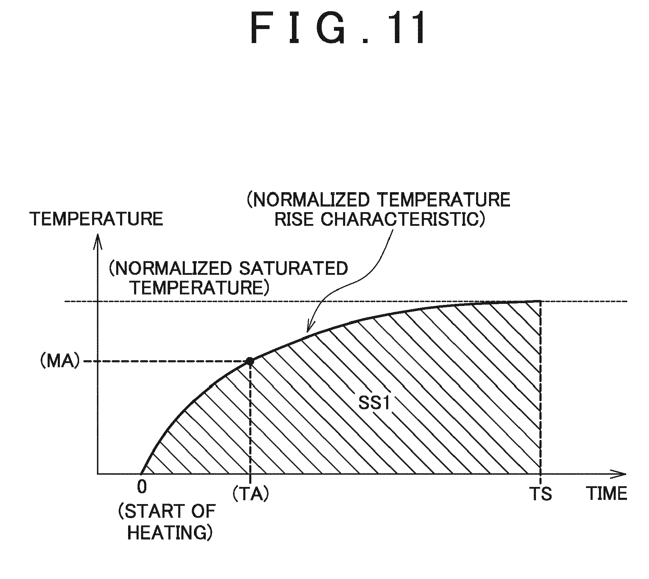

The time constant may be determined based on the curve shape of the normalized temperature rise characteristic and the area of the bonding part may be determined based on the determined time constant. However, it is easier to determine the area of a region surrounded by the curve shape and then to determine the area of the bonding part based on the determined area. The difference in the curve shape is expressed as the difference in the area of the region surrounded by the curve shape. Therefore, as illustrated in FIG. 11, the control unit 50 determines the area SS1 of the region surrounded by the curve shape of the normalized temperature rise characteristic from the heating start time point to the time point TS at which the normalized saturated temperature is reached.

The storage unit 60 stores in advance the parameter state-time constant characteristic (see FIG. 12) in which the area SS1 (the information on the time constant) of the curve-shaped part of the normalized temperature rise characteristic is correlated with the state of the parameter (the area of the bonding part). Then, the control unit 50 determines the state of the parameter (the area of the bonding part) on the basis of the determined area SS1 (the information on the time constant) with the curve shape and the parameter state-time constant characteristic (see FIG. 12) stored in advance in the storage unit 60. FIG. 12 illustrates an example where the control unit 50 determines that the area of the bonding part is equal to S1 when the area regarding the normalized temperature rise characteristic, which extends from the heating start time point to the time point TS at which the normalized saturated temperature is reached, is SS1.

The control unit 50 determines that the bonding state is appropriate when the determined state of the parameter (the determined area of the bonding part) is present in an allowable range. When the determined state of the parameter (the determined area of the bonding part) is not present in the allowable range, the control unit 50 determines that the bonding state is inappropriate. The threshold value used to determine whether the parameter state is present in the allowable range is stored in the storage unit 60 in advance.

In the above-mentioned processing procedure according to the second embodiment, the parameter state (the area of the bonding part) is determined on the basis of the information (the area of the curve-shaped part in this case) on the time constant of the normalized temperature rise characteristic. In the second embodiment, since the parameter state (the area of the bonding part) is determined on the basis of the difference in the curve shape regardless of the difference in the saturated temperature, it is possible to perform more accurate determination. The information on the time constant is not limited to the area of the curve-shape part, and may be information that specifies the time constant. For example, as illustrated in FIG. 11, the information on the time constant may be the temperature value MA at a predetermined time TA in the curve-shape part. Thus, the information on the time constant is based on the curve-shape part of the normalized temperature rise characteristic, which extends from the heating start time point to the time point TS at which the normalized saturated temperature is reached.

In the second embodiment, the parameter state of a measurement object is determined using the information on the time constant instead of the time constant. However, as is the case with the first embodiment, the time constant may be determined based on the normalized temperature rise characteristic and the parameter state of a measurement object may be determined. In this case, the parameter state-time constant characteristic is the same as that described in the first embodiment. By performing the above-mentioned processing procedure, it is possible to configure an optical non-destructive inspection apparatus in which the control unit determines whether the state of the parameter (the area of the bonding part) of the measurement object (the bonding structure 97) or the area of the bonding part of two members (the wire 93 and the electrode 92) is present in an allowable range.

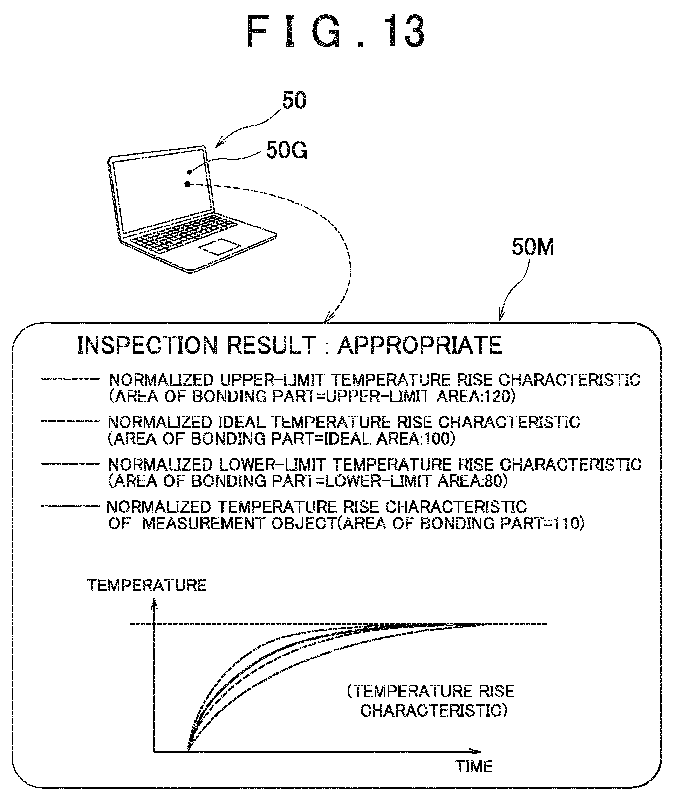

The display example in step S40 in the flowchart illustrated in FIG. 3 is illustrated in FIG. 13. FIG. 13 illustrates an example where information on the result of determination performed by the control unit is displayed on a screen 50M of a display unit 50G in the control unit 50. In this example, in a case where the determination result indicates that the area of the bonding part is appropriate, an upper-limit area of the bonding part is 120, an ideal area of the bonding part is 100, and a lower-limit area of the bonding part is 80, the area of the bonding part of the measurement object determined based on the time constant in the temperature rise characteristic and the parameter state-time constant characteristic or based on the information on the time constant in the normalized temperature rise characteristic and the parameter state-time constant characteristic is 110. Since an operator can easily determine that the state of the measurement object is present in an allowable range and is slightly deviated to the upper limit side by observing the number (110 in this case) indicating the area of the bonding part, it is easy to adjust a bonding apparatus so that the bonding area is slightly decreased to be close to the ideal area, which is very convenient for quality management.

FIG. 13 illustrates an example where a temperature rise characteristic graph is also displayed in a part of the screen 50M. In the temperature rise characteristic graph, the normalized temperature rise characteristic (the solid line in the screen 50M) of the measurement object, the normalized lower-limit temperature rise characteristic (which is a characteristic corresponding to the lower-limit area 80 (the one-dot chained line in the screen 50M in this case)), the normalized upper-limit temperature rise characteristic (which is a characteristic corresponding to the upper-limit area 120 (the two-dot chained line in the screen 50M in this case)), and the normalized ideal temperature rise characteristic (which is a characteristic corresponding to the ideal area 100 (the dotted line in the screen 50M in this case)) are indicated in an overlapping manner. Since an operator can easily determine that the state of the measurement object is present in an allowable range and is slightly deviated to the upper limit side by observing the temperature rise characteristic graph, it is easy to adjust a bonding apparatus so that the bonding area is slightly decreased to be close to the ideal area, which is very convenient for quality management.

Since the optical non-destructive inspection apparatus described in the present embodiment determines the state of the measurement object using the temperature rise characteristic in a period of several tens of ms until the temperature reaches the saturated temperature after the heating is started with the heating laser beam, the inspection time is extremely short as compared to the case (several tens of seconds to several minutes) in which the state is determined using the heat-dissipation state after heating. The present embodiment can be used to determine whether the bonding state of a wire-bonding part or the like is appropriate. Thus, it is possible to perform inspection with higher reliability, as compared to an operator's visual inspection or destructive inspection of an extracted sample. Even when the saturated temperature of the temperature rise characteristic differs, it is possible to more accurately determine the state of the parameter (the area of the bonding part) based on the difference in the curve shape, that is, based on the time constant of the curve shape of the temperature rise characteristic or the information on the time constant of the curve shape of the normalized temperature rise characteristic and the parameter state-time constant characteristic, without an influence of the difference in the saturated temperature. By compressing or extending the temperature rise characteristic in the temperature axis direction to obtain the normalized temperature rise characteristic, it is possible to more easily determine the state of the parameter (the area of the bonding part) using the information on the time constant which can be more easily acquired than the time constant.

Various modifications, additions, or deletions may be made to the process procedure, the configuration, the structure, the appearance, the shape, and the like of the optical non-destructive inspection method and the optical non-destructive inspection apparatus according to the present invention without departing from the scope of the present invention. An example of the infrared emission characteristic (FIG. 4) described in the embodiments and the positions of the first infrared wavelength λ1 and the second infrared wavelength λ2 shown in the infrared emission characteristic are only examples and the present invention is not limited to the examples. Expressions "equal to or greater than (≥)", "equal to or less than (≥)", "greater than (>)", "less than (<)", "B is present between A and C (A<B<C)", and the like may or may not include the equal sign. The numerical values used to describe the embodiments are only examples and the present invention is not limited to the numerical values.

## Claims

1. An optical non-destructive inspection method comprising:
a heating laser irradiation in which a control unit controls a heating laser beam source so as to irradiate a measurement spot set on a measurement object with a heating laser beam;
an emitted-infrared detection in which the control unit detects an infrared light beam with a predetermined infrared wavelength extracted out of light emitted from the measurement spot, by using an infrared detector; and
a temperature rise characteristic measurement in which the control unit measures a temperature rise characteristic based on a detected value detected in the emitted-infrared detection and a heating time during which irradiation with the heating laser beam is performed, the temperature rise characteristic being a temperature rise state of the measurement spot based on the heating time,
wherein the optical non-destructive inspection method is performed by an optical non-destructive inspection apparatus, and
wherein the optical non-destructive inspection apparatus includes
the heating laser beam source that emits the heating laser beam having a heating laser wavelength and having output power set so as to heat the measurement object without destroying the measurement object,
at least one infrared detector that detects an infrared light beam,
the control unit that controls the heating laser beam source and acquires a detection signal form the at least one infrared detector, and
a storage unit that stores a parameter state-time constant characteristic in which a state of a parameter corresponding to a state of the measurement object to be determined is defined, and a time constant indicating a curve shape of the temperature rise characteristic is correlated with the state of the parameter, the temperature rise characteristic varying depending on the state of the parameter.

2. The optical non-destructive inspection method according to claim 1, further comprising
a determination in which the control unit obtaines the time constant based on the curve shape of the measured temperature rise characteristic, and determines the state of the parameter of the measurement object based on the determined time constant and the parameter state-time constant characteristic stored in the storage unit,
wherein an interval, in which the curve shape is analyzed when the time constant is obtained, extends from a heating start time point to a time point at which a saturated temperature is reached, and
wherein the saturated temperature is a temperature at which an inclination of a graph indicating a temperature variation with respect to a time variation is equal to or less than a predetermined value.

3. The optical non-destructive inspection method according to claim 1, further comprising
a determination in which the control unit obtains a normalized temperature rise characteristic by compressing or extending the temperature rise characteristic in a temperature axis direction so that the saturated temperature in the measured temperature rise characteristic is equal to a preset normalized saturated temperature,
the control unit obtains the time constant or information on the time constant based on a curve shape of the obtained normalized temperature rise characteristic, and
the control unit determines the state of the parameter of the measurement object based on the obtained time constant or the obtained information on the time constant and the parameter state-time constant characteristic stored in the storage unit,
wherein an interval, in which the curve shape is analyzed when the time constant or the information on the time constant is obtained, extends from a heating start time point to a time point at which a saturated temperature is reached.

4. The optical non-destructive inspection method according to claim 3,
wherein the information on the time constant is an area of a region surrounded by a temperature rise curve shape of the normalized temperature rise characteristic, and
wherein the area of the region, which extends from the heating start time point to the time point at which the normalized saturated temperature is reached, is calculated.

5. The optical non-destructive inspection method according to any one of claims 1 to 4,
wherein the measurement object is a bonding structure including a bonding part in which two members are bonded,
wherein the measurement spot is set on a surface of one of the two members, wherein the state of the parameter is a magnitude of an area of the bonding part of the two members, and
wherein the control unit determines whether the area of the bonding part of the two members is in an allowable range by performing the determination.

6. The optical non-destructive inspection method according to any one of claims 2 to 5, wherein information on a result of the determination is displayed on a display unit that displays an image based on an output signal of the control unit.

7. An optical non-destructive inspection apparatus that performs the optical non-destructive inspection method according to any one of claims 1 to 6.
